# EUROPEAN PATENT SPECIFICATION

(11) **EP 2 004 907 B1**
(45) Date of publication and mention of the grant of the patent: **17.06.2009**
(21) Application number: 07727930.5
(22) Date of filing: 10.04.2007
(51) Int. Cl.: D21H 19/02, D21H 19/08, C23C 26/00, C23C 18/16, H05K 3/38

(54) **METHOD FOR APPLYING A METAL ON PAPER**
VERFAHREN ZUR APPLIZIERUNG EINES METALLS AUF PAPIER
PROCÉDÉ D'APPLICATION D'UN MÉTAL SUR DU PAPIER

(30) Priority: 10.04.2006 SE 0600806; 10.04.2006 US 791168 P; 27.10.2006 US 854922 P
(43) Date of publication of application: 24.12.2008
(73) Proprietor: Linea Tergi, Ltd., 3733 Limassol (CY)
(72) Inventor: LARSSON, Karl-Gunnar, 952 92 Kalix (SE); HULT, Anders, 187 34 Täby (SE)
(74) Representative: Carlsson, Carl Fredrik Munk
(86) International application number: PCT/EP2007/053462
(87) International publication number: WO 2007/116056

(56) References cited:
- EP-A1- 0 309 684
- EP-A2- 0 187 706
- EP-A2- 0 487 857
- GB-A- 1 222 969
- JP-A- 55 086 744
- JP-A- 60 169 186
- US-A- 5 225 495
- US-A- 5 919 402
- US-B1- 6 303 278

## Description

### Technical field

The present invention relates to a method for producing a metal coating on paper. The present invention further relates to a method of applying a distinct pattern of metal on paper. The present invention further relates to objects manufactured by such methods.

### Background

The application of metal coatings on surfaces serves many purposes. Traditionally a coating of a metal was applied to an object in order to improve its appearance or to stabilise the surface. By applying a pattern of conducting metal to paper, cheap and disposable circuits can be made.

In the state of the art attempts have been made to arrange a pattern of conducting material on paper and other materials. Previously a conducting polymer has been applied on the paper in the desired pattern. This has for instance the drawback that the conducting polymers are not as good conductors as metals are.

US 6,303,278 relates to a method of applying metal layers in distinct patterns. It discloses a method where the substrate surface is modified and brought into contact with monomers. The monomers will build up a polymer and conducting material is provided to the polymers and in a further step additional conducting material is added. The step where a conducting material is added to the polymers is carried out at low pH in HCl as mentioned in the production example 1 of US 6,303,278. Several different types of monomers may be used, for instance acrylic acid.

It is described as important that the substrate surface comprises secondary and/or tertiary hydrocarbon compounds.

In the state of the art attempts have also been made to apply metals in a conducting pattern on paper, however the adhesion of the metal layer has not been satisfying.

In the art several approaches have been used to improve the adhesion of metal to a substrate. For instance Yang, Shen, Li and Lu in Journal of Electronic Materials, February 1997, 26(2), pp. 78-82, have studied the adhesion of copper to parylene N. Parylene N was deposited on silicon using vapour deposition polymerisation. Copper was deposited on the parylene N film using partly ionised beam deposition. During the deposition plasma may be generated at high deposition rates and high ionisation. According to the publication the generation of plasma greatly increased the adhesion strength compared to other deposition techniques for the copper.

GB-A-1222969 discloses a method of depositing a metal layer on a substrate. The method comprises immersion of the substrate in an aqueous bath comprising metal ions, a complexing agent, and a reducing agent. The substrate is electroplated after the first electroless plating.

One problem in the state of the art concerning metal-coated paper is how to improve the adhesion of the metal coating to the paper.

### Short description of the present invention

An advantage of the present invention is that it is possible to use it in a continuous manufacturing process. Compared to the prior art it is more economical and suitable for large-scale production because commercially available equipment can be used for large-scale use of the present invention. When manufacturing circuits on paper, the present method will reduce the waste of metal that is etched away, since it is possible to use a method where a much thinner layer is etched creating a pattern. Further metal is then added to the pattern.

The processes utilise less amounts of chemicals, which in some countries are subject to regulations, compared to the traditional manufacturing methods.

Other advantages of the present invention include the properties of circuits manufactured using the present invention. Conductors on paper which have an hour-glass shaped cross section can be avoided and circuits with a more rectangular cross section can be manufactured with the present invention. Thus it is possible to manufacture circuits with better properties for high frequencies. The signal integrity will be improved in such circuits, compared to circuits according to the state of the art.

A further advantage is that it is possible to manufacture a conductor on paper with virtually the same thickness also for instance where the conductor leads from one side to another on a paper. This gives improved signal integrity.

Yet another advantage is that the present method allows manufacture of circuits which are built up sequentially with several layers of conductors in distinct patterns.

Yet another advantage is that the process according to the present invention allows manufacture of circuits with a very small line width.

The present invention relates to a new method for applying a first metal on paper according to the attached claims. The present invention also comprises objects manufactured according to the method according to the present invention. The present invention provides a method by which it is possible to apply a metal coating to paper with excellent adhesion and which is applicable to many types of paper and paper like material.

### Definitions

Before the method for producing a metal coating on paper is disclosed and described in detail, it is to be understood that this invention is not limited to particular configurations, process steps and materials disclosed herein as such configurations, process steps and materials may vary somewhat. It is also to be understood that the terminology employed herein is used for the purpose of describing particular embodiments only and is not intended to be limiting since the scope of the present invention is limited only by the appended claims and equivalents thereof.

It must be noted that, as used in this specification and the appended claims, the singular forms "a", "an" and "the" include plural referents unless the context clearly dictates otherwise.

In describing and claiming the present invention the following terminology will be used.

The term "initiator" as used throughout the description and in the claims denotes a substance, which has the capability to start a polymerisation reaction among monomers.

The term "monomer" as used throughout the description and in the claims denotes a substance, which is capable of forming a polymer in a polymerisation reaction.

The term "parylene" as used throughout the description and in the claims denotes a substituted or unsubstituted poly-para-xylylene. Examples of parylene include parylene N, parylene C, and parylene D. Parylene N denotes poly-para-xylylene, parylene C denotes a parylene with an additional chlorine atom in the aromatic ring. Parylene D denotes a parylene with two additional chlorine atoms in the aromatic ring.

The term "photoinitiator" as used throughout the description and in the claims denotes an initiator, which has the capability to start a polymerisation reaction when it is exposed to light and/or UV-light.

The term "polymer" as used throughout the description and in the claims denotes a compound, which is built up of repeating identical or different structural units.

The term "polymerisation" as used throughout the description and in the claims denotes a reaction where identical or different monomers build up a polymer.
The term "latent carboxylic group" as used throughout the description and in the claims denotes a chemical group, which has the capability of being transformed to a carboxylic group.

The term "paper" as used throughout the description and in the claims denotes all substrates based on cellulose.

### Short description of the present invention

In a first aspect the present invention relates to a method for applying a first metal on paper, which method comprises the steps a)producing polymers on the surface of said paper, said polymers comprising carboxylic groups and adsorbed ions of at least one second metal, said ions being adsorbed at a pH above 7, b) reducing said ions to the second metal and c) depositing said first metal on the reduced ions of said second metal.

In one embodiment the surface is treated using plasma before said polymers are produced. Alternatively or additionally the surface is treated in an alkaline solution. Optionally the surface is cleaned in another cleaning solution.

In one embodiment at least one primer is applied to said paper before step a), said primer is selected from the group consisting of a polyphenylene, a cycloaliphatic polyolefin and poly(4-methyl-1-pentene).

In one embodiment the primer is parylen. In another embodiment the primer is parylen N.

In one embodiment the polymers are produced on said surface by contacting said surface with a)at least one type of monomer, of which at least one comprises a carboxylic group, b)ions of at least one second metal selected from the group consisting of ruthenium, rhodium, palladium, osmium, iridium, platinum and copper, and c)at least one initiator, and wherein the pH is above 7. The sequence in which the above mentioned ingredients are mixed is not critical.

In an alternative embodiment the polymers are produced on said surface by contacting said surface with a)at least one type of monomer, of which at least one comprises a carboxylic group, and b)at least one initiator, and thereafter contacting said surface with a solution comprising ions of at least one second metal selected from the group consisting of ruthenium, rhodium, palladium, osmium, iridium, platinum and copper, said solution having a pH above 7.

The at least one type of monomer mentioned above is in one embodiment selected from the group consisting of acrylic acid and methacrylic acid.

In another embodiment the polymers are produced on said surface by contacting said surface with a)at least one type of monomer, of which at least one comprises a latent carboxylic group, and b)at least one initiator, and thereafter subjecting said surface to conditions suitable for transforming the latent carboxylic groups into carboxylic groups, and thereafter contacting said surface with a solution comprising ions of at least one second metal selected from the group consisting of ruthenium, rhodium, palladium, osmium, iridium, platinum and copper, said solution having a pH above 7.

In one embodiment the monomer comprising a latent carboxylic group is at least one substance selected from the group consisting of tert-butyl acrylate, maleic anhydride, methacrylic anhydride and acrylic anhydride.

The conditions suitable for transforming the latent carboxylic groups into carboxylic groups, are in one embodiment achieved by contacting the surface with a photo induced Brönsted acid.

The Brönsted acid is in one embodiment selected from the group consisting of a sulfonium salt and an iodonium salt.

The initiator used as described above is in one embodiment selected from the group consisting of thioxantone, camphorquinone, benzophenone, 4-chloro benzophenone, 4,4' dichloro benzophenone, 4-benzyl benzophenone, benzoyl naphthalene, xanthone, anthraquinone, 9-fluorenone, acetophenone, benzoyl dimethylketal, hydroxy-cyclo-hexyl-acetophenone, bi-acetyl, 3,4-hexane-di-one, 2,3-pentane-di-one, 1-phenyl-1,2-propane-di-one, benzene, benzoylformic acid, formaldehyde, acetic aldehyde, acetone, 2-pentanone, 3-pentanone, cyclohexanone, methanol sulphonate esters of benzophenone and mixtures thereof.

In one embodiment the ions of the at least one second metal are palladium ions and the method further comprises ammonium ions. The ammonium ions are in this particular embodiment in the same solution as the palladium ions.

In one embodiment the ions are adsorbed at a pH above 10.

In one embodiment the first metal is selected from the group consisting of copper, silver, gold, nickel, titanium, and chromium.

In a particular embodiment the surface is further subjected to the steps of d)selectively depositing a third metal to said surface in a distinct pattern, and e) removing said first and second metal from said surface on the parts which are not covered by said third metal.

In one particular embodiment the third metal is copper.

In an alternative embodiment the metal is applied in a distinct pattern on said paper. This is achieved by performing any one or several of the steps outlined in claim 1 in the desired distinct pattern on said paper.

In yet another alternative embodiment the metal is applied on the entire paper. In this embodiment the metal is preferably but not necessarily applied in a uniform layer.

In a second aspect the present invention encompasses an object manufactured according to the method described herein.

In one embodiment the object has a thickness of the layer of the first metal from about 2µm to about 5µm.

In one embodiment the object comprises electrical circuits.

In one embodiment the object comprises more than one layer of conductors electrically insulated from each other. This is an SBU process.

### Detailed description of the present invention

These steps according to the method of the present invention will now be explained in greater detail.

The present invention relates to a new method of applying a first metal on paper. An object wherein some parts are made of paper may be coated according to the present invention.

All substrates based on cellulose are encompassed within the present invention. Non limiting examples of substrates based on cellulose include acid-free paper, all-rag paper, archival paper, art paper, banknote paper, baryta paper, board, bookbinding board, brochure cover paper, brush coated paper, bubble coated paper, calendered paper, coated folding boxboard, coated paper, corrugated fibreboard, curtain coated paper, cotton, cotton based paper, cover paper, dip coated paper, double faced corrugated fibreboard, facing, felt board, fibreboard, fine paper, glazed millboard, grease resistant paper, hot melt coated paper, index board, kraft liner, kraft paper, kraft sack paper, lampshade paper, leather fibre board, leather pulp board, letter paper, lined chipboard, liner paper, liquid carton board, machine-glazed paper, machine-made board, paper, paperboard, PE-coated paper, PET-coated paper, recycled paper, single coated paper, smoothing roll coated paper, solid fibreboard, and wrapping paper.

In one embodiment of the present invention coated paper is used as a substrate. In another embodiment polymer-coated paper is used as a substrate. In one embodiment polyethylene-coated paper is used. In another embodiment the substrate is paper coated with polyethylene terephthalate.

The object to be coated is preferably clean, when the process is started.

The object to be coated is in one embodiment first treated with plasma. The treatment makes it possible to wet objects which otherwise are difficult adhere to. The plasma treatment also has a cleaning effect. The plasma treatment may be conducted in any gas that gives a polar surface and at any suitable pressure. In one embodiment of the present invention the plasma treatment is carried out at ambient pressure in air. The present inventors have found that treatment with plasma in combination with the rest of the method as described herein gives excellent results. Although an initial plasma treatment is preferred, it should be noted that for some objects a plasma treatment is not mandatory. As an alternative to plasma a cleaning in an alkaline solution is sufficient for some papers.

After the plasma treatment a primer is optionally applied to at least a part of the surface of the object. Non-limiting examples of a primer are a polyphenylene, and a cycloaliphatic polyolefin. Examples of cycloaliphatic polyolefins include copolymers made from ethylene and norbornene. Further more specific examples of a primer include poly(4-methyl-1-pentene), parylene N, parylene C, parylene D, parylene F, parylene A, parylene AM, and parylene HT. Parylene is preferably applied from the gas phase. Application devices for parylene are commercially available and a person skilled in the art can apply a layer of a parylene. The thickness of the primer layer can vary within wide boundaries. In one embodiment the layer is thinner than 100 µm, and in another embodiment the layer is from about 2 to about 20 µm.

After the application of a primer, a metal is applied on the primer. There are several approaches for applying a metal on the polyphenylene. In one embodiment the application of a metal comprises the application of a polymer on the surface. The inventors have discovered that the method with application of a polymer on the surface gives excellent results together with a primer selected from the group consisting of a polyphenylene, a cycloaliphatic polyolefin and poly(4-methyl-1-pentene). In one embodiment of the present invention a polymer is grafted on the primer.

The polymer on the surface comprises carboxylic groups. There are several approaches for achieving carboxylic groups on the polymers. Examples of such approaches are described more in detail below.

In one embodiment of the present invention monomers comprising carboxylic groups are used to build up the polymer with the aid of an initiator for the polymerisation reaction. It is also possible to use a mixture of different monomers, i.e. a mixture comprising monomers containing carboxylic groups and monomers that do not contain carboxylic groups.

In another embodiment of the present invention monomers with latent carboxylic groups are incorporated when building up the polymer on the object. The polymer can be entirely built up of monomers comprising latent carboxylic groups. Alternatively the polymer can be built up of both monomers comprising latent carboxylic groups and monomers without latent carboxylic groups. The polymer on the object is then subjected to conditions such that the latent carboxylic groups in the polymers are transformed into carboxylic groups.

One non limiting example of a latent carboxylic group is maleic anhydride. If maleic anhydride is used as a monomer it is incorporated in the polymer during the polymerisation and is then subjected to conditions such that it is transformed into carboxylic groups. In another embodiment of the present invention a latent carboxylic acid such as tert-butyl acrylate is used to build up a polymer, where after it is transformed into a carboxylic group using suitable conditions. Another example of a latent carboxyl group is a protected carboxy group.

A non limiting example of a suitable condition for transformation of latent carboxylic groups into carboxylic groups is treatment with a Brönsted acid. In one embodiment of the present invention the Brönsted acid is produced in a photoreaction, i.e. a photo induced Brönsted acid. Non-limiting examples of Brönsted acids are sulfonium salts and iodonium salts. A person skilled in the art realises that there are several ways of transforming a latent carboxylic group into a carboxylic group. Maleic anhydride can for instance be transformed into maleic acid by heat treatment.

In all of the above-described different approaches to produce polymers comprising carboxylic groups, at least one initiator is used to initiate the polymerisation reaction. The initiator can either be a photoinitiator or another initiator. When a photoinitiator is used it is understood that the method also encompasses irradiation with light of a suitable wavelength. Examples of suitable photoinitiators are compounds comprising carbonyl groups, such as aromatic ones. Aromatic ketones and aromatic aliphatic ketones absorb electromagnetic waves, especially in the interval of about 200 to about 500 nm, making these compounds useful as initiators according to the invention. In one embodiment of the present invention the initiator according to the present invention is chosen from the group consisting of said initiator is selected from the group consisting of thioxantone, camphorquinone, benzophenone, 4-chloro benzophenone, 4,4' dichloro benzophenone, 4-benzyl benzophenone, benzoyl naphthalene, xanthone, anthraquinone, 9-fluorenone, acetophenone, benzoyl dimethylketal, hydroxy-cyclo-hexyl-acetophenone, bi-acetyl, 3,4-hexane-di-one, 2,3-pentane-di-one, 1-phenyl-1,2-propane-di-one, benzene, benzoylformic acid, formaldehyde, acetic aldehyde, acetone, 2-pentanone, 3-pentanone, cyclohexanone, methanol sulphonate esters of benzophenone and mixtures thereof.

The carboxylic groups of the polymers have adsorbed metal ions. The metal ions are always adsorbed at a pH above 7. Below there are provided two alternative approaches for adsorbing the ions onto the polymers:
In a first approach the ions of said second metal are mixed together with the monomers before the polymerisation takes place. In a second approach the ions are added in a subsequent step when the polymers already are produced on the surface. The first approach when the ions of the second metal are added to the monomer solution has one step less.

In the first approach the solution of monomers comprises ions of at least one second metal selected from the group consisting of ruthenium, rhodium, palladium, osmium, iridium, platinum and copper. The amount of ions of the second metal may vary within a broad interval. A non-limiting example of a suitable amount of ions is approximately one metal ion with the charge +2 per two monomer molecules with the charge -1.

In the second approach the surface of the object is contacted with a solution comprising ions of a second metal. The second metal is at least one metal selected from the group consisting of ruthenium, rhodium, palladium, osmium, iridium, platinum and copper. For the second approach with a separate adsorption step for ions of the second metal, the present inventors have found that in contrast to the state of the art described in US 6,303,278, the solution should have a pH value above 7. The higher pH value as compared to the known prior art leads to a better adhesion of the metal layer. In one embodiment of the present invention the pH value is about 11. In another embodiment of the present invention the pH value is about 11.5. In another embodiment of the present invention the pH value is above 10. In another embodiment of the present invention the pH value is above 9. In another embodiment of the present invention the pH value is above 8.

In another embodiment of the present invention, the solution comprising ions of a second metal further comprises ammonium ions. In another embodiment of the present invention the solution comprising ions of a second metal.comprises palladium ions and ammonium ions. A person skilled in the art realises that counter-ions have to be present.

Ions of the second metal, which are bound to the polymer, are reduced to said second metal. This reduction is carried out irrespectively of which approach has been used to apply the metal ions to the polymers. In one embodiment of the present invention the reduction is achieved with a chemical reaction using a reducing solution for instance sodium borohydride. In one embodiment of the present invention the reduction comprises a photochemical reaction. In another embodiment of the present invention the reduction involves a thermal treatment. A person skilled in the art can in the light of this description realise several ways to reduce metal ions to metal. Thus also other ways of reducing the metal ions can be used within the scope of the present invention.

When the ions of the second metal have been reduced to metallic form and after an optional second plasma treatment the first metal is deposited on the surface by contacting it with a solution comprising ions of the first metal. In one embodiment of the present invention the solution comprises ions of the first metal, a complexing agent and a reduction agent. In one embodiment of the present invention the solution for depositing the first metal is a standard solution that is commercially available. In one embodiment of the present invention the thickness of the layer of the first metal is below 100µm. In another embodiment of the present invention the thickness is in the range 0.25-40µm, in another embodiment of the present invention the thickness is in the range 0.5-20µm, in another embodiment of the present invention the thickness is in the range 1-10µm and in another embodiment of the present invention the thickness is in the range 2-5µm.

In one embodiment the paper is heated after the application of the metal in order to evaporate undesired substances and gases formed during the process. The paper should not be heated too much. In one embodiment the maximum temperature is below 130°C, in another embodiment the maximum temperature is below 100°C. The duration of the heat treatment is not critical. Examples of duration times range from a few seconds to several hours. Typically the duration of the heat treatment is within the interval from a few minutes to about 30 minutes.

The objects coated with metal according to the present invention may be used in many contexts. One application according to the present invention of paper coated with metal is described below.

In one embodiment of the present invention a board coated with a metal layer without any pattern according to the present invention is used for the manufacture of a circuit. Further metal is deposited with electroplating to the surface in a desired pattern. In one embodiment the surface is covered with a mask and further metal is deposited in a distinct pattern determined by the mask. The mask is then removed. This creates a board with a thin coating of a metal and a distinct pattern thereon consisting of a thicker metal coating. The board is then subjected to etching for a time that is sufficiently long to etch away the thin coating but sufficiently short to leave the pattern consisting of the thick coating. A person skilled in the art can in the light of this description and the claims determine a suitable etching time. This gives a printed wire board with a desired distinct pattern of metal on the paper.

The process according.to the present invention has many advantages. One advantage is improved adhesion. Another advantage is that less metal is needed to produce the metallized papers. As a consequence less metal needs to be removed by etching in the first step of manufacturing. Further the problems of "hour-glass" shaped conductors and "under-etching", due to the etching liquid acting not only on the surface but also on the sides of the conductors, are eliminated. This makes it possible to produce narrower conductors. It is also possible to use existing technology and existing production lines with only minor modifications.

An alternative use of papers according to the present invention for the manufacture of circuits is to apply the metal in a distinct pattern on paper. This is in one embodiment achieved by applying the reagents in the desired pattern. In an alternative embodiment this is achieved by irradiation in the desired pattern. In a specific form of this embodiment this is achieved by creating a photo induced Brönsted acid in a distinct pattern on the paper.

In one embodiment of the present invention a SBU procedure is used. The present invention encompasses use of a sequential build-up (SBU). In this embodiment a desired pattern of conductors is applied on paper, where after an insulating layer is applied. On the insulating layer another desired pattern of conductors are applied. This process is repeated until the desired number of layers with conductors are achieved. Contact between the conductors in the different layers is achieved by methods known to a person skilled in the art of printed wire boards.

Other features of the invention and their associated advantages will be evident to a person skilled in the art upon reading the description and the examples.

It is to be understood that this invention is not limited to the particular embodiments shown here. The following examples are provided for illustrative purposes and are not intended to limit the scope of the invention since the scope of the present invention is limited only by the appended claims and equivalents thereof.

### Examples

### Example 1

A piece of paper, "PET 140+40" from the company StoraEnso was used as a substrate. This is a paper coated on one side with PET (polyethylene terephtalate). The piece of paper was attached with adhesive tape to a polymeric substrate and the edges were sealed with adhesive tape to protect the uncoated paper surface from the liquid. The paper was subjected to plasma treatment in a plasma reactor in air at ambient pressure for 1 minute. Shortly after the plasma treatment the paper was contacted with a solution comprising 1 wt% acrylic acid and 0.01wt% thioxantone. The paper was irradiated with UV-light for 10 seconds and the polymerisation reaction was allowed to proceed for 4 minutes. The paper was rinsed in running water for 30 seconds. The polymerisation reaction yielded a polymer with covalent bonds to the paper, i.e. grafted to the paper. The paper was then contacted for 30 seconds with an aqueous solution of 0.48wt% of PdCl₂ and 5.2wt% of a concentrated aqueous NH₃-solution. Thus the solution comprised ammonium ions (NH₄⁺). The pH of the solution was adjusted with an aqueous NH₃-solution to 11.5. The paper was then rinsed in running water for 30 seconds. Then the palladium ions, which were adsorbed to the polymers, were reduced by contacting the paper with a freshly made aqueous solution of 1wt% NaBH₄. Thereafter the paper was rinsed in running water for 30 seconds. After this step the paper was contacted with an autocatalytic bath for deposition of copper. The bath was an aqueous standard bath for the deposition of copper comprising CuSO₄, EDTA (ethylenediaminetetra-acetic acid), HCHO, and NaOH. The pH value was 11.7 and the temperature was 35°C. After the copper deposition the paper was rinsed in running water for 30 seconds and dried. This yielded an epoxy resin with a 2 µm thick coating of copper. The same method as in example 2 was used. This yielded paper with a flexible coating of 2µm copper. Adhesion was tested by applying a piece of adhesive tape to the paper and then quickly tearing it away. No copper was removed and thus the adhesion was deemed to be excellent.

### Example 2

A piece of ordinary paper designed for copying machines was used as a substrate. This paper was not polymer coated. The paper was used directly in the process. The same method as in example 1 was used. This yielded paper with a flexible coating of 2µm copper. Adhesion was tested by applying a piece of adhesive tape to the paper and then quickly tearing it away. No copper was removed and thus the adhesion was deemed to be excellent.

## Claims

1. A method for applying a first metal on paper, which method comprises the steps
a. applying at least one primer to said paper, said primer is selected from the group consisting of a polyphenylene, a cycloaliphatic polyolefin and poly(4-methyl-1-pentene),
b.producing polymers on the surface of said paper, said polymers comprising carboxylic groups and adsorbed ions of at least one second metal, said ions being adsorbed at a pH above 7,
c. reducing said ions to the second metal, and
d. depositing said first metal on the reduced ions of said second metal.

2. The method according to claim 1, wherein said surface is treated using plasma before step a).

3. The method according to any one of claims 1-2, wherein said primer is parylen N.

4. The method according to any one of claims 1 to 3, wherein said polymers are produced on said surface by contacting said surface with
• at least one type of monomer, of which at least one comprises a carboxylic group,
• ions of at least one second metal selected from the group consisting of ruthenium, rhodium, palladium, osmium, iridium, platinum and copper, and
• at least one initiator,
and wherein the pH is above 7.

5. The method according to any one of claims 1 to 3, wherein said polymers are produced on said surface by contacting said surface with
• at least one type of monomer, of which at least one comprises a carboxylic group, and
• at least one initiator,
and thereafter contacting said surface with a solution comprising ions of at least one second metal selected from the group consisting of ruthenium, rhodium, palladium, osmium, iridium, platinum and copper, said solution having a pH above 7.

6. The method according to any one of claims 1 to 3, wherein said polymers are produced on said surface by contacting said surface with
• at least one type of monomer, of which at least one comprises a latent carboxylic group, and
• at least one initiator,
and thereafter subjecting said surface to conditions suitable for transforming the latent carboxylic groups into carboxylic groups,
and thereafter contacting said surface with a solution comprising ions of at least one second metal selected from the group consisting of ruthenium, rhodium, palladium, osmium, iridium, platinum and copper, said solution having a pH above 7.

7. The method according to claim 6 wherein said conditions suitable for transforming the latent carboxylic groups into carboxylic groups, are achieved by contacting the surface with a photo induced Brönsted acid.

8. The method according to any one of claims 1-7, wherein said ions of at least one second metal are palladium ions and said method further comprises ammonium ions.

9. The method according to any one of claims 1-8, wherein said ions being adsorbed at a pH above 10.

10. The method according to any one of claims 1-9, wherein said first metal is selected from the group consisting of copper, silver, gold, nickel, titanium, and chromium.

11. The method according to any one of claims 1-10, wherein said surface is further subjected to the steps of
d. selectively depositing a third metal to said surface in a distinct pattern, and
e. removing said first and second metal from said surface on the parts which are not covered by said third metal.

12. The method according to any one of claims 1-11, wherein metal is applied in a distinct pattern on said paper.

13. The method according to any one of claims 1-11, wherein metal is applied on the entire paper.

14. The method according to claim 11, wherein said third metal is copper.

15. An object comprising paper manufactured according to any one of claims 1 to 14.

16. The object according to claim 15, comprising more than one layer of conductors electrically insulated from each other.

## Patentansprüche

1. Verfahren zum Aufbringen eines ersten Metalls auf Papier, wobei das Verfahren die folgenden Schritte umfasst:
a. Aufbringen mindestens eines Primers auf das genannte Papier, wobei der genannte Primer aus der Gruppe bestehend aus einem Polyphenylen, einem cycloaliphatischen Polyolefin und Poly-(4-methyl-1-penten) ausgewählt ist,
b. Herstellen von Polymeren auf der Oberfläche des genannten Papiers, wobei die genannten Polymere Carboxylgruppen und adsorbierte Ionen von mindestens einem zweiten Metall umfassen, wobei die genannten Ionen bei einem pH-Wert von mehr als 7 adsorbiert werden,
c. Reduzieren der genannten Ionen auf das zweite Metall und
d. Abscheiden des genannten ersten Metalls auf den reduzierten Ionen des genannten zweiten Metalls.

2. Verfahren nach Anspruch 1, wobei die genannte Oberfläche vor Schritt a) unter Verwendung von Plasma behandelt wird.

3. Verfahren nach einem der Ansprüche 1 - 2, wobei der genannte Primer Parylen N ist.

4. Verfahren nach einem der Ansprüche 1 bis 3, wobei die genannten Polymere auf der genannten Oberfläche hergestellt werden, indem die genannte Oberfläche mit
- mindestens einem Monomertyp, von denen mindestens einer eine Carboxylgruppe umfasst,
- Ionen von mindestens einem zweiten Metall, das aus der Gruppe bestehend aus Ruthenium, Rhodium, Palladium, Osmium, Iridium, Platin und Kupfer ausgewählt ist, und
- mindestens einem Initiator in Kontakt gebracht wird,
und wobei der pH-Wert höher als 7 ist.

5. Verfahren nach einem der Ansprüche 1 bis 3, wobei die genannten Polymere auf der genannten Oberfläche hergestellt werden, indem die genannte Oberfläche mit
- mindestens einem Monomertyp, von denen mindestens einer eine Carboxylgruppe umfasst, und
- mindestens einem Initiator in Kontakt gebracht wird
und danach die genannte Oberfläche mit einer Lösung in Kontakt gebracht wird, die Ionen von mindestens einem zweiten Metall umfasst, das aus der Gruppe bestehend aus Ruthenium, Rhodium, Palladium, Osmium, Iridium, Platin und Kupfer ausgewählt ist, wobei die genannte Lösung einen pH-Wert von mehr als 7 aufweist.

6. Verfahren nach einem der Ansprüche 1 bis 3, wobei die genannten Polymere auf der genannten Oberfläche hergestellt werden, indem die genannte Oberfläche mit
- mindestens einem Monomertyp, von denen mindestens einer eine latente Carboxylgruppe umfasst, und
- mindestens einem Initiator in Kontakt gebracht wird
und danach die genannte Oberfläche Bedingungen ausgesetzt wird, die zum Umwandeln der latenten Carboxylgruppen in Carboxylgruppen geeignet sind,
und danach die genannte Oberfläche mit einer Lösung in Kontakt gebracht wird, die Ionen von mindestens einem zweiten Metall umfasst, das aus der Gruppe bestehend aus Ruthenium, Rhodium, Palladium, Osmium, Iridium, Platin und Kupfer ausgewählt ist, wobei die genannte Lösung einen pH-Wert von mehr als 7 aufweist.

7. Verfahren nach Anspruch 6, wobei die genannten Bedingungen, die zum Umwandeln der latenten Carboxylgruppen in Carboxylgruppen geeignet sind, erreicht werden, indem die Oberfläche mit einer photoinduzierten Brönsted-Säure in Kontakt gebracht wird.

8. Verfahren nach einem der Ansprüche 1 - 7, wobei die genannten Ionen von mindestens einem zweiten Metall Palladiumionen sind und das genannte Verfahren weiterhin Ammoniumionen umfasst.

9. Verfahren nach einem der Ansprüche 1 - 8, wobei die genannten Ionen bei einem pH-Wert von mehr als 10 adsorbiert werden.

10. Verfahren nach einem der Ansprüche 1 - 9, wobei das genannte erste Metall aus der Gruppe bestehend aus Kupfer, Silber, Gold, Nickel, Titan und Chrom ausgewählt ist.

11. Verfahren nach einem der Ansprüche 1 - 10, wobei die genannte Oberfläche weiterhin den folgenden Schritten unterzogen wird:
d. selektives Abscheiden eines dritten Metalls auf der genannten Oberfläche in einem ausgeprägten Muster und
e. Entfernen des genannten ersten und zweiten Metalls von der genannten Oberfläche an den Abschnitten, die nicht von dem genannten dritten Metall bedeckt sind.

12. Verfahren nach einem der Ansprüche 1 - 11, wobei Metall in einem ausgeprägten Muster auf das genannte Papier aufgebracht wird.

13. Verfahren nach einem der Ansprüche 1 - 11, wobei Metall auf das gesamte Papier aufgebracht wird.

14. Verfahren nach Anspruch 11, wobei das genannte dritte Metall Kupfer ist.

15. Gegenstand, der Papier umfasst, das nach einem der Ansprüche 1 bis 14 hergestellt wurde.

16. Gegenstand nach Anspruch 15, der mehr als eine Schicht von Leitern umfasst, die voneinander elektrisch isoliert sind.

## Revendications

1. Procédé d'application d'un premier métal sur du papier, ledit procédé comprenant les étapes suivantes :
a. l'application d'au moins un amorceur sur ledit papier, ledit amorceur étant choisi dans le groupe constitué par un polyphénylène, une polyoléfine cycloaliphatique et un poly(4-méthyl-1-pentène),
b. la production de polymères sur la surface dudit papier, lesdits polymères comprenant des groupes carboxyliques et des ions adsorbés d'au moins un second métal, lesdits ions étant adsorbés à un pH supérieur à 7,
c. la réduction desdits ions du second métal, et
d. le dépôt dudit premier métal sur les ions réduits dudit second métal.

2. Procédé selon la revendication 1, dans lequel ladite surface est traitée avec un plasma avant l'étape a).

3. Procédé selon l'une quelconque des revendications 1 et 2, dans lequel ledit amorceur est le parylène N.

4. Procédé selon l'une quelconque des revendications 1 à 3, dans lequel lesdits polymères sont produits sur ladite surface en mettant en contact ladite surface avec
- au moins un type de monomère, dont au moins un comprend un groupe carboxylique,
- des ions d'au moins un second métal choisi dans le groupe constitué par le ruthénium, le rhodium, le palladium, l'osmium, l'iridium, le platine et le cuivre, et
- au moins un initiateur,
et dans lequel le pH est supérieur à 7.

5. Procédé selon l'une quelconque des revendications 1 à 3, dans lequel lesdits polymères sont produits sur ladite surface en mettant en contact ladite surface avec
- au moins un type de monomère, dont au moins un comprend un groupe carboxylique, et
- au moins un initiateur,
puis en mettant en contact ladite surface avec une solution comprenant des ions d'au moins un second métal choisi dans le groupe constitué par le ruthénium, le rhodium, le palladium, l'osmium, l'iridium, le platine et le cuivre, ladite solution ayant un pH supérieur à 7.

6. Procédé selon l'une quelconque des revendications 1 à 3, dans lequel lesdits polymères sont produits sur ladite surface en mettant en contact ladite surface avec
- au moins un type de monomère, dont au moins un comprend un groupe carboxylique latent, et
- au moins un initiateur,
puis en soumettant ladite surface à des conditions appropriées pour transformer les groupes carboxyliques latents en groupes carboxyliques,
puis en mettant en contact ladite surface avec une solution comprenant des ions d'au moins un second métal choisi dans le groupe constitué par le ruthénium, le rhodium, le palladium, l'osmium, l'iridium, le platine et le cuivre, ladite solution ayant un pH supérieur à 7.

7. Procédé selon la revendication 6, dans lequel lesdites conditions appropriées pour transformer les groupes carboxyliques latents en groupes carboxyliques sont obtenues en mettant en contact la surface avec un acide de Brönsted photo-induit.

8. Procédé selon l'une quelconque des revendications 1 à 7, dans lequel lesdits ions d'au moins un second métal sont des ions de palladium et ledit procédé comprend en outre des ions d'ammonium.

9. Procédé selon l'une quelconque des revendications 1 à 8, dans lequel lesdits ions sont adsorbés à un pH supérieur à 10.

10. Procédé selon l'une quelconque des revendications 1 à 9, dans lequel ledit premier métal est choisi dans le groupe constitué par le cuivre, l'argent, l'or, le nickel, le titane et le chrome.

11. Procédé selon l'une quelconque des revendications 1 à 10, dans lequel ladite surface est en outre soumise aux étapes suivantes :
d. le dépôt sélectif d'un troisième métal sur ladite surface en un motif distinct, et
e. l'élimination desdits premier et second métaux de ladite surface sur les parties qui ne sont pas recouvertes par ledit troisième métal.

12. Procédé selon l'une quelconque des revendications 1 à 11, dans lequel le métal est appliqué en un motif distinct sur ledit papier.

13. Procédé selon l'une quelconque des revendications 1 à 11, dans lequel le métal est appliqué sur la totalité du papier.

14. Procédé selon la revendication 11, dans lequel ledit troisième métal est le cuivre.

15. Objet comprenant un papier fabriqué selon l'une quelconque des revendications 1 à 14.

16. Objet selon la revendication 15, comprenant plus d'une couche de conducteurs électriquement isolés les uns des autres.
